Europäisches Patentamt

European Patent Office

Office européen des brevets

(11) Publication number: **0 138 250**
A2

# EUROPEAN PATENT APPLICATION

(21) Application number: **84201313.8**

(22) Date of filing: **12.09.84**

(51) Int. Cl.⁴: **H 01 J 37/20**

(30) Priority: **19.09.83 US 533708**

(43) Date of publication of application: **24.04.85**
**Bulletin 85/17**

(84) Designated Contracting States: **DE FR GB NL**

(71) Applicant: **North American Philips Corporation,**
**100 East 42nd Street 9th Floor, New York,**
**N.Y. 10017 (US)**

(72) Inventor: **Rodgers, Irene Piscopo, c/o INT.**
**OCTROOIBUREAU B.V. Prof.Holstlaan 6, NL-5656 AA**
**Eindhoven (NL)**

(74) Representative: **Scheele, Edial François et al,**
**INTERNATIONAAL OCTROOIBUREAU B.V. Prof.**
**Holstlaan 6, NL-5656 AA Eindhoven (NL)**

(54) **Structure for increasing number of specimens viewed in an electron microscope.**

(57)    The present invention is directed to a multiple specimen holder for use in a scanning electron microscope so that numerous specimens can be viewed in the electron microscope without need for removing a specimen from the electron microscope each time a different specimen is to be viewed.

0138250

Structure for increasing number of specimens
viewed in an electron microscope.

The present invention is directed to a structure
for increasing the number of specimens viewed in an electron
microscope. In addition, the area of the specimen that can
be fully transversed is increased, and mounting and vieweing
a 3" wafer is enhanced.

Electron microscopes provide a specimen stage at
a location in the electron beam for viewing the specimen.
Normally, a single specimen is formed in the electron beam
for viewing, and in order to view a number of different
specimens, the electron microscope has to go through an
operation of increasing pressure in the specimen chamber,
removal of the first specimen, insertion of the second
specimen and re-evacuation of the specimen chamber in order
to be able to form the electron beam for viewing images of
the specimen. This is a time consuming endeavor making the
viewing of numerous specimens or multiple specimens very
difficult.

The present invention, on the other hand, provides
a structure to load a multiple number of specimens into the
specimen chamber for viewing with an electron beam without
the hardships of the prior systems.

In particular, a structure is provided in which
upto eight different specimens can be placed in the specimen
chamber of the electron microscope with a control structure
for placing different ones of the specimens into the
electron beam. In addition to this structure, the specimen
scan area can be vastly increased relative to a given
specimen.

The structure and arrangement of the presently
claimed invention may be seen more clearly by reference
to the drawing figures which illustrate without limitation
arrangements of the present invention, and wherein

Figure 1 illustrates a partial view of the gearing structure in the arrangement of the present invention;

Figure 2 illustrates a top-view of a multiple speciman holder to be utilized in accordance with the present invention;

Figure 3 illustrates a cross-section of the arrangement of Figure 2;

Figure 4 illustrates another type of specimen holder for the present invention; and

Figure 5 illustrates, in partial view, the arrangement of the present invention in the specimen chamber of an electron microscope.

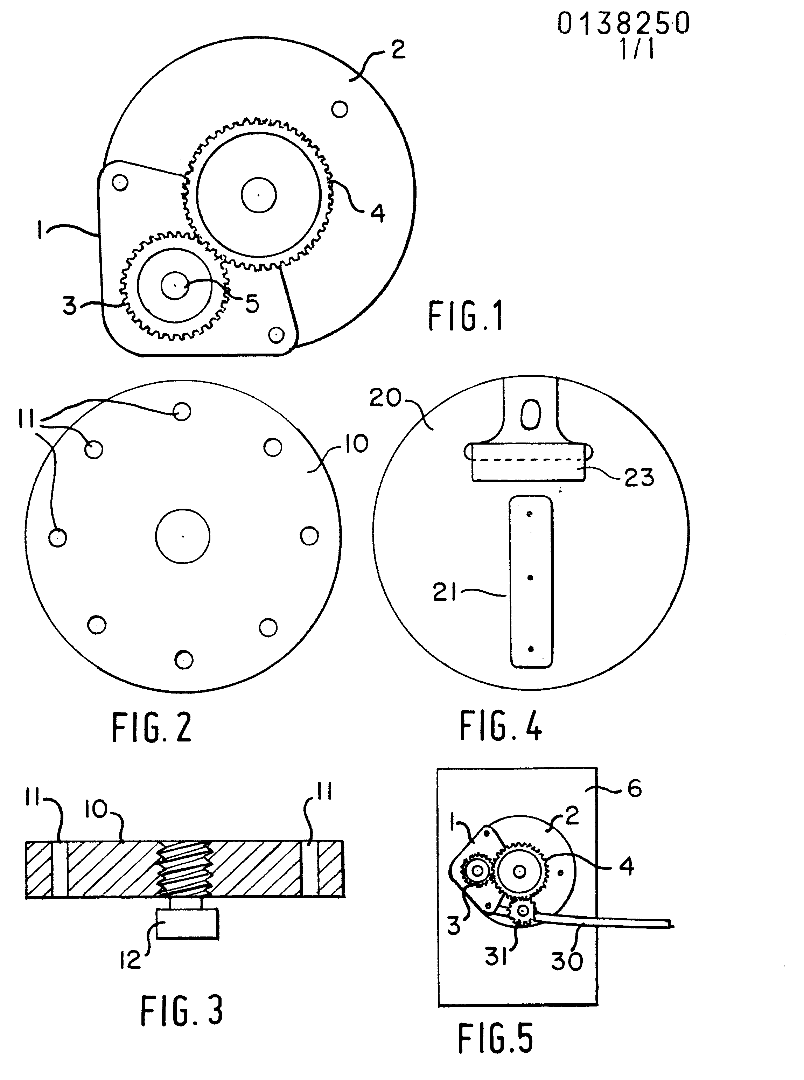

In this invention, the stage gear 4 mounted in the specimen chamber 6 of an electron microscope, as seen in Figures 1 and 5, meshes with an additional gear wheel 3 of the multiple specimen arrangement according to the present invention. This additional gear wheel 3 is mounted on a generally U-shaped flat plate 1 which is attached to the stage gear mechanism 2.

The additional gear wheel 3 meshes with the stage gear 4. A multiple specimen holder can then be rotated upon rotation of the stage gear 4. This is accomplished by way of the rotation control mechanism 30, illustrated in Fig. 5, which has a rotary gear 31 meshing with stage gear 4. This rotation control allows rotation of the stage gear 4 from the outside of the electron microscope, and rotation of the stage gear 4 causes rotation of the additional gear 3.

A sample plate 10 is mounted on the additional gear 3 by way of the male threaded portion 12 (see Fig.3) being inserted into the opening 5 tapped into the additional gear 3. This allows rotation of the plate 10 upon rotation of the additional gear 3 by the external rotation control structure 30, 31.

The specimen plate 10, as seen in Fig. 2, has a number of openings 11 spaced around the periphery.

These openings 11 constitute an opening for a pin-type specimen mount by which various specimens can be mounted onto the plate 10. The specimen stubs are held firmly in place by means of an Allen key.

Upon mounting such different specimens onto the plate 10, the plate 10 can be mounted onto the gear wheel 3. The specimen chamber of the electron microscope can then be sealed, evacuated, and the different specimens on the plate 10 can be investigated with the electron beam upon rotation of the specimen plate 10. Each specimen at the positions 11 can be place into the electron beam upon operation of the external rotation control mechanism 30, 31.

As an additional arrangement for use in the present invention, a plate 20 can be mounted into the opening 5 of the additional gear wheel 3. This plate 20 can carry specimens, such as silicon wafers. The wafers are inserted onto the mount 21, and the plate 20 is rotated for viewing different locations on the wafers.

The mechanism of the present invention enables the viewing of a number of different specimens in a scanning electron microscope, without the requirements of increasing pressure in the specimen chamber, removing the specimen, reinserting a new specimen, and re-evacuation of the specimen chamber for viewing with an electron beam. This provides a significant advantage in electron microscope work.

In addition to viewing multiple specimens, areas of specimens larger than 20mm x 20mm may be scanned. Also, the capability of superimposing a large 3" specimen mount onto the multiple specimen carrier is available.

While several embodiments to the present invention have been illustrated and described, the present invention includes all variations and features which may be evident from the claims.

1.      A structure for increasing the number of specimens viewed in an electron microscope comprising

an electron microscope stage gear mechanism capable of rotation,

an additional gear mechanism attached to said stage mechanism for rotation therewith,

a plate attached to said additional gear mechanism by way of a threaded coupling tapped into said additional gear mechanism, said plate having a plurality of locations for mounting specimens, and

means for rotating said plate by rotating said stage gear mechanism so that each specimen is examined in an electron beam path of said electron microscope.

2.      A structure according to Claim 1, wherein eight specimen pin locations are provided in said plate for holding eight specimens respectively in said electron beam path.

3.      A structure according to Claim 1, wherein said plate is provided with locations for mounting thin flat specimens.

4.      A structure according to Claim 3, wherein said thin flat specimens are silicon wafers.

FIG.1

FIG.2

FIG.3

FIG.4

FIG.5

PHA 21175